# FASCICULE DE BREVET EUROPEEN

(11) **EP 2 285 869 B1**
(45) Date de publication et mention de la délivrance du brevet: **04.12.2013**
(21) Numéro de dépôt: 09745998.6
(22) Date de dépôt: 27.04.2009
(51) Int. Cl.: C08G 81/02, B32B 27/06, H01L 31/00, B32B 27/28, H01L 31/048, H01L 31/05

(54) **COMPOSITION A BASE DE POLYMERE GREFFE POLYAMIDE ET SON UTILISATION DANS LES MODULES PHOTOVOLTAIQUES**
POLYAMIDPFROPFPOLYMERZUSAMMENSETZUNG UND IHRE VERWENDUNG FÜR PV-MODULE
POLYAMIDE GRAFT POLYMER COMPOSITION AND USE THEREOF IN PHOTOVOLTAIC MODULES

(30) Priorité: 28.04.2008 FR 0852849; 16.05.2008 US 53781 P
(43) Date de publication de la demande: 23.02.2011
(73) Titulaire: ARKEMA FRANCE, 92700 Colombes (FR)
(72) Inventeur: JOUSSET, Dominique, F-27470 Serquigny (FR); BIZET, Stéphane, F-27170 BARC (FR); CARTIER, Laurent B., Montgomery, PA 19087 (US)
(86) Numéro de dépôt international: PCT/FR2009/050769
(87) Numéro de publication internationale: WO 2009/138679

(56) Documents cités:
- EP-A- 1 022 309
- EP-A- 1 065 731
- EP-A- 1 342 764
- WO-A-02/28959
- WO-A-2007/039697
- WO-A-2008/043958
- FR-A- 2 878 265
- FR-A- 2 882 060
- US-A1- 2004 144 415

## Description

### Domaine de l'invention

L'invention a pour objet un film de protection inférieur d'un module photovoltaïque, le module photovoltaïque contenant ce film de protection, ainsi que le procédé de fabrication de ce module photovoltaïque.

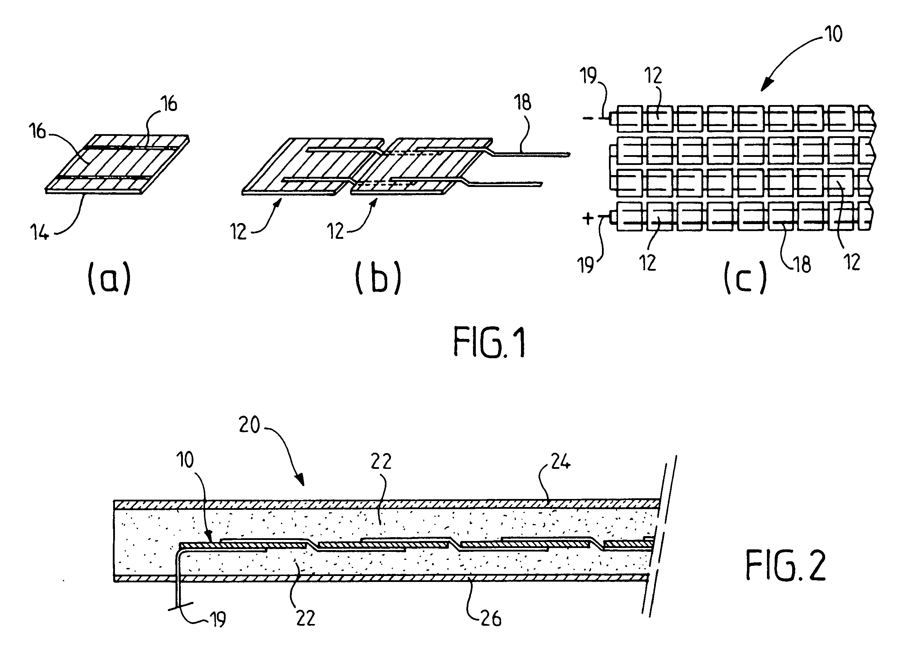

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules solaires. Un module solaire comprend une « pile photovoltaïque », cette pile étant capable de transformer l'énergie lumineuse en électricité. Sur la Figure 1, on a représenté une pile photovoltaïque classique ; cette pile photovoltaïque (10) comprend des cellules (12), une cellule contenant un capteur photovoltaïque (14), généralement à base de silicium traité afin d'obtenir des propriétés photoélectriques, en contact avec des collecteurs d'électrons (16) placés au-dessus (collecteurs supérieurs) et au-dessous (collecteurs inférieurs) du capteur photovoltaïque. Les collecteurs (16) supérieurs d'une cellule sont reliés aux collecteurs (16) inférieurs d'une autre cellule (12) par des barres conductrices (18), constituées généralement d'un alliage de métaux. Toutes ces cellules (12) sont connectées entre elles, en série et/ou en parallèle, pour former la pile photovoltaïque (10). Lorsque la pile photovoltaïque (10) est placée sous une source lumineuse, elle délivre un courant électrique continu, qui peut être récupéré aux bornes (19) de la pile (10).

En référence à la Figure 2, le module solaire (20) comprend la pile photovoltaïque (10) de la Figure 1 enrobée dans un « encapsulant » (22). Une couche protectrice supérieure (24) et un film de protection inférieur (26), encore connu sous le nom de « backsheet », sont disposées de part et d'autre la pile encapsulée.

L'encapsulant (22) doit épouser parfaitement la forme de l'espace existant entre la pile photovoltaïque (10) et les couches protectrices (24) et (26) afin d'éviter la présence d'air, ce qui limiterait le rendement du module solaire. L'encapsulant (22) doit également empêcher le contact des cellules (12) avec l'eau et l'oxygène de l'air, afin d'en limiter la corrosion. Cet encapsulant est généralement une composition comprenant un copolymère d'éthylène et d'acétate de vinyle réticulé.

La protection au choc et à l'humidité de la pile photovoltaïque (10) est assurée par la couche protectrice supérieure (24), généralement en verre.

Le film de protection inférieur (26), contribue à la protection à l'humidité du module solaire (20) et à l'isolation électrique des cellules (12) pour éviter tout contact avec l'environnement extérieur.

### Etat de l'art

Les différentes couches (pile photovoltaïque, couche protectrice supérieure, encapsulant, backsheet) doivent adhérer à leurs différentes interfaces pour assurer un bon rendement du module solaire et pour éviter que des gaz ou de l'eau s'infiltrent et causent un vieillissement prématuré de ce module.

Une solution possible est d'utiliser une couche d'adhésif ou de liant entre les différentes couches. On peut par exemple citer la demande WO2004091901, qui décrit une structure de backsheet pour modules solaires, dans laquelle un adhésif à base de polyester ou de polyuréthane est compris entre une couche d'un copolymère éthylène - acétate de vinyle (EVA) et une couche d'un polymère barrière, afin de permettre l'adhérence de ces deux couches.

Une autre solution est d'utiliser un encapsulant, dont on va décrire quelques exemples dans la suite de l'état de l'art de la présente description, cet encapsulant devant présenter une adhérence avec la couche protectrice supérieure, le backsheet et la pile photovoltaïque.

En présence de rayonnement solaire, il se crée un échauffement à l'intérieur du module solaire et des températures de 70°C (ou plus) peuvent être atteintes. Les propriétés thermomécaniques, et en particulier la tenue au fluage, de l'adhésif, du liant ou de l'encapsulant doivent donc être conservées à ces températures pour que celui-ci ne soit pas déformé. La tenue au fluage est plus particulièrement importante dans le cas de l'encapsulant : en effet, en cas de fluage, la pile peut rentrer en contact avec l'air et/ou les couches protectrices supérieure et/ou inférieure, ce qui entraîne une diminution du rendement du module solaire, voire une dégradation de la pile et du module solaire.

De plus, pour ne pas diminuer le rendement du module solaire, il est nécessaire que l'encapsulant permette la transmission des ondes lumineuses du rayonnement solaire vers les cellules. Toujours pour ne pas diminuer le rendement, il est souhaitable que ces ondes soient peu diffractées, c'est-à-dire que l'encapsulant doit être, à l'oeil nu, transparent ou légèrement translucide, la transparence étant quantifiée par son « niveau de trouble » ou encore « Haze », qui doit être faible. Il est nécessaire également que l'encapsulant ait de bonnes propriétés d'isolation électrique, afin d'éviter tout court-circuit à l'intérieur du module.

L'utilisation dans les modules solaires d'un encapsulant à base de copolymère d'éthylène - acétate de vinyle (EVA), décrit par exemple dans la demande JP19870174967, constitue la solution la plus répandue à l'heure factuelle. L' EVA a une bonne transparence. Cependant, son adhérence avec les couches protectrices n'est pas satisfaisante et des agents d'aide à l'adhérence, communément appelés « agents de couplage », doivent donc être ajoutés. Ces agents sont des produits généralement choisis parmi les silanes ou les titanates organiques. De plus, l'EVA se dégrade sous l'influence du rayonnement solaire et de la température; on observe alors un dégagement d'acide acétique corrodant les cellules photovoltaïques. Par ailleurs, on remarque également un vieillissement de l'encapsulant au cours du temps, qui se matérialise notamment par un jaunissement important, conduisant à une diminution du rendement du module solaire.

En outre, la tenue au fluage de l'EVA n'est pas suffisante dans les conditions d'utilisation des modules solaires. Il est donc nécessaire que ce copolymère soit réticulé ; il n'est donc plus thermoplastique. Les modules sont alors plus difficiles à recycler après cette étape de réticulation de l'encapsulant. Par ailleurs, cette étape de réticulation constitue une étape supplémentaire dans le procédé de fabrication des modules solaires, ce qui conduit donc à une perte de productivité.

Lors de la fabrication des modules solaires, les différentes couches protectrices et d'encapsulant peuvent être assemblées par laminage. Dans ce procédé, l'assemblage des différentes couches formant le module solaire se fait souvent par sous-tirage sous vide. Ce sous-tirage sous vide est assuré par l'intermédiaire d'une membrane en silicone qui vient se plaquer contre le module solaire. Lors de la mise sous vide, les agents de couplage, qui sont volatils, sont aspirés et se déposent sur la membrane. Or, la silicone se dégrade au contact des agents de couplage ; il est donc nécessaire d'en supprimer ou d'en limiter leur usage afin de permettre l'utilisation de cette membrane en silicone sur une plus longue durée pour la fabrication en série de plusieurs modules solaires.

En outre, dans le domaine du verre feuilleté, on utilise des couches de verre ou/et de PMMA que l'on associe à des liants à base d'EVA ou de polyvinylbutyral (PVB) ; pour les mêmes raisons de tenue au fluage et d'adhérence, ces liants doivent être réticulés et contenir des agents de couplage. On rencontre les mêmes problèmes de capacité à être recyclés, de productivité et de vieillissement que pour les modules solaires.

Pour le verre feuilleté, on utilise le même type de procédé de fabrication et en particulier les mêmes températures que ceux utilisés pour la fabrication des modules solaires.

Pour éviter une étape de réticulation et pour résoudre les problèmes de propriétés thermomécaniques de l'encapsulant, notamment de tenue au fluage, il a été envisagé, dans la demande publiée sous le numéro WO95/22843, l'utilisation comme encapsulant de ionomère dans les modules solaires. Ce ionomère est un copolymère thermoplastique, non réticulé, d'éthylène et d'acide (méth)acrylique partiellement neutralisé par des cations d'éléments des groupes I, II ou III du tableau périodique (par exemple de cation de Zinc ou de Calcium). L'adhérence de cet encapsulant avec la pile photovoltaïque et les couches de protection est correcte. Ces ionomères présentent également, à l'oeil nu une bonne transparence. Cependant, bien que les propriétés thermomécaniques soient meilleures que celles de l'EVA non réticulé, la tenue au fluage n'est pas suffisante. En effet, la formation d'un réseau ionique permet au ionomère de conserver une certaine cohésion au-delà de sa température de fusion, mais sans que sa tenue au fluage soit pleinement satisfaisante. Un autre problème majeur du ionomère est sa viscosité élevée aux températures habituelles de fabrication des modules solaires (généralement comprises dans la gamme allant de 120°C à 160°C). Or, cette viscosité élevée est un frein à la productivité : en effet, dans un procédé continu de fabrication de film, par exemple un procédé de fabrication par extrusion, le débit de film en sortie d'extrudeuse diminue lorsque la viscosité augmente.

Dans le brevet US6414236, l'encapsulant est un terpolymère éthylène - acrylate d'alkyle -anhydride maléique. Cet encapsulant est destiné à améliorer la tenue au vieillissement du module solaire. Cependant, sa résistance au fluage reste médiocre et sa réticulation est donc nécessaire : l'encapsulant n'est donc plus thermoplastique.

Par ailleurs, on connait les documents FR 2878265, WO 2008/043958, WO 02/28959 et FR 2882060 qui divulguent des compositions thermoplastiques.

Il est donc nécessaire de trouver une composition, que l'on peut utiliser comme liant ou comme encapsulant, en particulier dans les modules solaires, ladite composition étant thermoplastique et ne nécessitant pas nécessairement de réticulation. Elle doit pouvoir également présenter, lors de sa fabrication, une viscosité faible pour pouvoir permettre une productivité optimale.

Tout ou partie des inconvénients et problèmes présentés ci-dessus s'appliquent non seulement à tout type de module solaire, de verre feuilleté mais également à tout autre type de cellule photovoltaïque et circuit intégré utilisant le silicium comme semi-conducteur.

### Résumé de l'invention

Aussi, l'invention a pour objet l'utilisation comme liant et/ou comme encapsulant ou dans les modules solaires d'au moins une composition thermoplastique selon la revendication 1.

De manière surprenante, la composition selon l'invention combine des propriétés suffisantes d'isolation électrique, de propriétés barrières à l'eau et l'oxygène, de pouvoir adhésif et de tenue au fluage à des températures d'utilisation de l'ordre de 70°C voire plus, même sans étape de réticulation, ces propriétés permettant son utilisation avantageuse dans les modules solaires. Un autre avantage de la composition est sa faible viscosité en comparaison avec les ionomères, ce qui facilite sa mise en oeuvre et la productivité de structures selon l'invention.

L'homme du métier pourra aisément sélectionner le polymère greffé polyamide ayant la température d'écoulement adaptée à la température maximale d'utilisation désirée, à savoir supérieure à cette température.

On décrit dans la demande US 2004/0144415 un backsheet comprenant un ionomère dispersé dans une phase polyamide, cette phase étant continue ou co-continue contrairement à l'invention. Le film n'est pas utilisé comme encapsulant. De plus, il s'agit d'un simple mélange et le polyamide n'est pas greffé au ionomère. Ce backsheet n'est pas transparent. Aucune propriété d'adhérence de ce film n'a été décrite.

Dans la demande EP1342764, il est décrit un mélange d'un polymère greffé polyamide avec une résine tackifiante (au moins 20% en masse du total de la composition). Ce document concerne l'application des colles « Hot melt », qui est un domaine très éloigné des liants, des encapsulants et des panneaux solaires.

Avantageusement la composition contient moins de 20% en masse de résine tackifiante par rapport à la masse totale de la composition, de préférence de 0 à 10%, par exemple de 0 à 5%. L'absence de résine tackifiante ou sa faible teneur permet de conférer à la composition une transparence et/ou un trouble à la lumière visible et/ou une tenue au fluage adapté à l'utilisation dans un module solaire et/ou une vitre feuilletée. De manière surprenante, même lorsque la composition ne comprend pas de résine tackifiante, le pouvoir d'adhérence de la composition est suffisant pour pouvoir être utilisé comme liant ou comme encapsulant.

Bien que la composition selon l'invention ait un pouvoir d'adhérence suffisant sans que des agents de couplage soient ajoutés, elle peut en comprendre de manière avantageuse.

Le pouvoir d'adhérence de la composition est encore augmenté par rapport à une composition selon l'invention n'en comprenant pas, tout en conservant sans réticulation les propriétés satisfaisantes pour l'utilisation dans les modules solaires ou la vitre feuilletée. Pour une adhérence équivalente, la quantité d'agents de couplage nécessaire est moindre en comparaison avec les formulations à base d'EVA.

Avantageusement, la composition comprend jusque 20% de la masse totale de la composition, par exemple de 0,01 à 10% en masse et préférentiellement de 0,1 à 5%.

Avantageusement, la température d'écoulement du polymère greffé polyamide est la température de fusion ou la température de transition vitreuse des greffons polyamide.

Selon un premier mode de l'invention, la température d'écoulement du polymère greffé polyamide est comprise dans la gamme allant de 115 à 160°C.

Dans cette gamme de température d'écoulement préférentielle, la composition présente une tenue au fluage exceptionnelle aux températures d'utilisation des modules solaires. Lorsqu'elle est utilisée pour la fabrication de structures comme les modules solaires ou la vitre feuilletée, les gammes de température de fabrication de ces structures sont identiques à celles habituellement utilisées.

Selon un second mode de réalisation, la température d'écoulement du polymère greffé polyamide est comprise dans la gamme allant de 75 à 115°C, et avantageusement de 85 à 115°C.

Dans ce mode de réalisation, la viscosité et/ou la température de mise en oeuvre du polymère greffé polyamide est particulièrement basse, ce qui permet d'améliorer la productivité et/ou les coûts de fabrication de la composition selon l'invention et des structures réalisées à partir de cette dernière. Bien que la tenue au fluage de la composition soit légèrement moins élevée que celle observée pour le premier mode, cette composition garde une très bonne tenue aux températures d'utilisation dans les modules solaires.

De manière préférée, la composition de l'invention transmet la lumière visible et/ou est transparente à la lumière visible. Selon l'invention, la composition transmet la lumière visible lorsqu'elle présente une transmission supérieure ou égale à 80% ; la composition est transparente à la lumière visible lorsqu'elle présente un niveau de trouble inférieur ou égal à 10%. La transmission et le niveau de trouble de la composition sont évalués selon la norme ASTM D1003, sur un film de ladite composition de 500 µm d'épaisseur et pour au moins une longueur d'onde du domaine visible (de 380 à 780 nm). Cette composition est avantageusement utilisée comme encapsulant dans les modules solaires ou comme liant pour la fabrication d'une vitre feuilletée.

De manière préférée, la composition de l'invention est nanostructurée. Selon l'invention, on entend par composition nanostructurée une composition comprenant au moins deux phases non miscibles et dont au moins une de ces phases a une de ses dimensions (ou plus d'une) inférieure à 780 nm. Avantageusement, cette dimension est inférieure à 380nm, par exemple dans la gamme allant de 60 à 380nm et mieux de 60 à 300 nm. Les dimensions des phases peuvent être aisément mesurées par l'homme du métier avec la technique connue de Microscopie Electronique à Transmission et un logiciel standard de traitement d'images. Avantageusement, en vue d'obtenir une bonne nanostructuration du polymère greffé polyamide, on utilise comme masse molaire des greffons polyamide une masse moyenne en nombre comprise dans la gamme allant de 1000 à 5000g/mol, de préférence comprise dans la gamme allant de 2000 à 3000 g.mol⁻¹.

De manière surprenante, lorsque la composition est nanostructurée, on obtient une composition qui transmet la lumière visible et/ou est transparente à la lumière visible selon la définition de l'invention, adhésive et ayant une très bonne tenue au fluage à des températures pouvant atteindre 70°C, voire plus. Combinées à ses propriétés barrière à l'eau, barrière aux gaz et ses propriétés électriques, cette composition thermoplastique peut être très avantageusement utilisée comme encapsulant dans le domaine des modules solaires, sans qu'il soit obligatoire d'effectuer une réticulation de la composition.

On préfère que les greffons polyamide comprennent au moins un greffon copolyamide. La composition selon l'invention transmet alors la lumière visible de manière plus importante et/ou est plus transparente à la lumière visible que pour un polymère greffé polyamide dont les greffons sont en homopolyamide.

De manière avantageuse, la température de fusion du tronc polyoléfine est inférieure à 100°C. La composition selon l'invention transmet alors la lumière de manière plus importante et/ou est plus transparente que pour un tronc polyoléfine ayant une température de fusion supérieure à 100°C. Selon un mode particulier, le tronc polyoléfine n'a pas de température de fusion, ce qui augmente encore la transparence.

De manière préférée, le tronc polyoléfine comprend en moyenne un nombre de restes de monomères (X) supérieur ou égal à 1,3 et/ou préférentiellement inférieur ou égal à 10. Les dimensions de la (ou des) phase nanostructurée de la composition diminuent lorsque ces conditions sont respectées, ce qui améliore encore les propriétés de transparence et de tenue au fluage.

Le monomère insaturé (X) compris dans ou sur le tronc polyoléfine est préférentiellement l'anhydride maléique.

Le rendement de la réaction de condensation des greffons polyamide sur le tronc polyoléfine est alors amélioré par rapport aux troncs polyoléfines n'en comprenant pas.

De manière avantageuse, le tronc polyoléfine est un copolymère.

La composition selon l'invention est alors plus souple que lorsque le tronc polyoléfine est un homopolymère ; elle est mieux adaptée pour son utilisation comme encapsulant, par exemple dans les modules solaires.

Avantageusement, le tronc polyoléfine comprenant le reste de (X) du polymère greffé polyamide est un copolymère éthylène-(méth)acrylate d'alkyle.

La composition a alors un meilleur comportement au vieillissement sous l'effet de la lumière visible et de la température que l'EVA.

Les extrémités du greffon polyamide comprennent avantageusement au moins une fonction amine.

Le rendement de la réaction de condensation des greffons polyamide sur le tronc polyoléfine est alors amélioré.

La composition peut également comporter un autre polymère, dit complémentaire, qui est différent d'une résine tackifiante. De préférence, ce polymère complémentaire est miscible ou partiellement miscible avec le polymère greffé polyamide. Ce polymère complémentaire peut représenter moins de 55% de la masse totale de la composition et préférentiellement moins de 20% de la composition.

On peut alors diminuer le prix de la composition. Dans le cas où ce polymère complémentaire est miscible ou partiellement miscible, la composition présente alors un excellent compromis coût/transmission de la lumière visible et/ou transparence à la lumière visible.

De préférence, la composition comprend moins de 10% en masse d'élastomère et par exemple de 0 à 5% en poids.

De préférence, la composition comprend au moins 75% en masse du polymère greffé polyamide.

Elle présente alors une meilleure tenue au fluage que celle qui comprend moins de 75% du polymère greffé polyamide ; la composition présente également une meilleure transparence et/ou laisse mieux passer la lumière visible.

La composition peut comprendre en outre au moins un des composants additionnels choisis parmi les agents réticulant, les absorbants UV, les charges minérales, les plastifiants, les additifs retardateurs de flamme, les composés colorants ou azurants.

Lors de l'utilisation de la composition comme liant dans une vitre feuilletée ou comme encapsulant dans un module solaire, la nature et/ou la concentration de ces composants doivent être telles que la composition finale reste transparente et/ou transmet la lumière visible. A titre d'exemple, ces composés peuvent représenter de 0 à 20% de la masse totale de la composition, par exemple de 0,01 à 10%.

Selon un mode particulier de l'invention, la composition contient, par rapport à la masse totale de la composition :
i) de 41 à 100% en masse de polymère greffé polyamide,
ii) de 0 à 20% en masse d'agent de couplage et non polymérique,
iii) de 0 à 20% en masse de composants additionnels,
iv) de 0 à 19% en masse d'un polymère autre qu'une résine tackifiante.

L'invention se rapporte également à une structure comprenant la composition, cette structure ayant de préférence une épaisseur comprise entre 5µm et 2mm.

Cette structure peut être multicouche et comprendre au moins un support sur lequel est appliquée la composition thermoplastique selon l'invention. En cas d'utilisation de la structure comme module solaire, le support peut constituer la couche supérieure ou inférieure de protection ou encore la pile photovoltaïque. Ce support peut être constitué de verre, de polymère et en particulier de PMMA, de métal ou de tout type de capteur photovoltaïque.

L'invention a également pour objet un module solaire ou une vitre feuilletée, en particulier du verre feuilleté, qui sont des structures particulières selon l'invention. Dans le cas d'une vitre feuilletée, la composition peut jouer le rôle de liant entre deux couches d'une vitre feuilletée.

La composition selon l'invention peut être avantageusement utilisée comme liant et/ou comme encapsulant. Elle peut également être avantageusement utilisée dans les modules solaires ou dans les vitres feuilletées.

### Description des Figures annexées

La description qui va suivre est donnée uniquement à titre illustratif et non limitatif en référence aux figures annexées, dans lesquelles :
La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.
La Figure 2, déjà décrite, représente une coupe transversale d'un module solaire.

### Description détaillée de l'invention

S'agissant du tronc polyoléfine, c'est un polymère comprenant comme monomère une α-oléfine.

On préfère les α-oléfines ayant de 2 à 30 atomes de carbone.

A titre d'α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène. Dans le cadre de la présente invention, le terme d'α-oléfine comprend également le styrène. On préfère le propylène et tout spécialement l'éthylène comme α-oléfine.

Cette polyoléfine peut-être un homopolymère lorsqu'une seule α-oléfine est polymérisée dans la chaîne polymère. On peut citer comme exemples le polyéthylène (PE) ou le polypropylène (PP).

Cette polyoléfine peut aussi être un copolymère lorsqu'au moins deux comonomères sont copolymérisés dans la chaîne polymère, l'un des deux comonomères dit le « premier comonomère» étant une α-oléfine et l'autre comonomère, dit « deuxième comonomère », est un monomère capable de polymériser avec le premier monomère.

A titre de deuxième comonomère, on peut citer :
- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,91 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé (X) pouvant réagir sur une fonction acide et/ou amine du greffon polyamide par une réaction de condensation. Selon la définition de l'invention, le monomère insaturé (X) n'est pas un « deuxième comonomère ».

Comme monomère insaturé (X) compris sur le tronc polyoléfine, on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé (X) est préférentiellement un époxyde insaturé. Dans le cas où l'extrémité réactive du greffon en polyamide est une fonction amine, le monomère insaturé (X) est avantageusement un époxyde insaturé et préférentiellement un anhydride d'acide carboxylique insaturé:

Selon une version avantageuse de l'invention, le nombre préféré de monomère insaturé (X) fixé en moyenne sur le tronc polyoléfine est supérieur ou égal à 1,3 et/ou préférentiellement inférieur ou égal à 10.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé (X) est obtenu par polymérisation des monomères (premier comonomère, deuxième comonomère éventuel, et éventuellement monomère insaturé (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2,16kg, ASTM D 1238).

Les greffons polyamide peuvent être soit des homopolyamides, soit des copolyamides.

Sont notamment visés par l'expression "greffons polyamides" les homopolyamides aliphatiques qui résultent de la polycondensation:
- d'un lactame,
- ou d'un acide alpha,omega-aminocarboxylique aliphatique,
- ou d'une diamine aliphatique et d'un diacide aliphatique.

A titre d'exemples de lactame, on peut citer le caprolactame, l'oenantholactame et le lauryllactame.

A titre d'exemples d'acide alpha,omega-aminocarboxylique aliphatique, on peut citer l'acide aminocaproïque, l'acide amino-7-heptanoïque, l'acide amino-11-undécanoïque et l'acide amino-12-dodécanoïque.

A titre d'exemples de diamine aliphatique, on peut citer l'hexa-méthylènediamine, la dodécaméthylènediamine et la triméthylhexaméthylène diamine.

A titre d'exemples de diacide aliphatique, on peut citer les acides adipique, azétaïque, subérique, sébacique et dodécanedicarboxylique.

Parmi les homopolyamides aliphatiques, on peut citer, à titre d'exemple et de façon non limitative, les polyamides suivants : le polycaprolactame (PA6) ; le polyundécanamide (PA11, commercialisé par ARKEMA sous la marque Rilsan^{®}) ; le polylauryllactame (PA12, également commercialisé par ARKEMA sous la marque Rilsan^{®}) ; le polybutylène adipamide (PA4.6) ; le polyhexaméthylène adipamide (PA6.6) ; le polyhexaméthylène azélamide (PA6.9) ; le polyhexaméthylène sébaçamide (PA-6.10) ; le polyhexaméthylène dodécanamide (PA6.12) ; le polydécaméthylène dodécanamide (PA10.12) ; le polydécaméthylène sébaçanamide (PA10.10) et le polydodecaméthylène dodécanamide (PA12.12).

Sont également visés par l'expression "polyamides semi-cristallins" les homopolyamides cycloaliphatiques.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12.

Sont également visés par l'expression "greffons polyamide" les homopolyamides semi-aromatiques qui résultent de la condensation :
- d'une diamine aliphatique et d'un diacide aromatique, tel que l'acide téréphtalique (T) et l'acide isophtalique (I). Les polyamides obtenus sont alors couramment appelés "polyphtalamides" ou PPA ;
- d'une diamine aromatique, telle que la xylylènediamine, et plus particulièrement la métaxylylènediamine (MXD) et d'un diacide aliphatique.

Ainsi, et de manière non limitative, on peut citer les polyamides 6.T, 6.1, MXD.6 ou encore MXD.10.

Les greffons polyamide rentrant en jeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est particulier. On considère que c'est l'association d'une diamine et d'un diacide, c'est-à-dire le couple diamine.diacide (en quantité équimolaire), qui correspond au monomère. Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :
- d'au moins deux lactames,
- d'au moins deux acides alpha,omega-aminocarboxyliques aliphatiques,
- d'au moins un lactame et d'au moins un acide alpha,omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,
la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides amorphes que l'on peut utiliser dans le cadre de l'invention, on peut citer par exemple les copolyamides contenant des monomères semi-aromatiques.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions, selon sa valeur c'est un polyamide ou un oligomère de polyamide.

Avantageusement, les greffons polyamide sont monofonctionnels.

Pour que le greffon polyamide ait une terminaison monoamine, il suffit d'utiliser un limiteur de chaîne de formule : 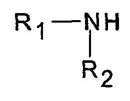 dans laquelle :
- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R'1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Avantageusement, les greffons polyamide ont une masse molaire comprise entre 1000 et 5000 g/mol et de préférence entre 2000 et 3000 g/mol.

La polycondensation définie ci-dessus s'effectue selon les procédés habituellement connus, par exemple à une température comprise en général entre 200 et 300°C, sous vide ou sous atmosphère inerte, avec agitation du mélange réactionnel. La longueur de chaîne moyenne du greffon est déterminée par le rapport molaire initial entre le monomère polycondensable ou le lactame et le limiteur monofonctionnel de polymérisation. Pour le calcul de la longueur de chaîne moyenne, on compte habituellement une molécule de limiteur de chaîne pour une chaîne de greffon.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de (X) s'effectue par réaction d'une fonction amine ou acide du greffon polyamide sur le reste de (X). Avantageusement, on utilise des greffons polyamide monoamine et on crée des liaisons amides ou imides en faisant réagir la fonction amine sur la fonction du reste de (X).

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière. Avantageusement, des agents de couplage sont ajoutés lors du compoundage.

Pour obtenir une composition nanostructurée, on peut ainsi mélanger le greffon polyamide et le tronc dans une extrudeuse, à une température généralement comprise entre 200 et 300 °C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225.

Le polymère greffé polyamide de la présente invention présente avantageusement une organisation nanostructurée. Pour obtenir ce type d'organisation, on utilisera préférentiellement par exemple des greffons présentant une masse molaire en nombre Mₙ comprise entre 1000 et 5000g/mol et plus préférentiellement entre 2000 et 3000 g/mol. On utilisera également préférentiellement 15 à 30% en masse de greffons polyamide et un nombre de monomères (X) compris entre 1,3 et 10.

Avantageusement, la température d'écoulement du polymère greffé polyamide est inférieure ou égale à 160°C, ce qui permet une température de mise en oeuvre particulièrement bien adaptée aux techniques actuelles de fabrication de panneaux solaires.

Grâce aux éléments donnés dans cette description, l'homme du métier pourra ainsi ajuster les différents paramètres (choix des greffons, proportions, choix de la polyoléfine) pour choisir les propriétés finales de température d'écoulement, de fluidité, de propriétés thermomécaniques, de transmission de la lumière et de transparence.

La composition serait également conforme à l'invention si elle comprenait un mélange de polymère greffé polyamide tels que définis précédemment.

On ne sortirait pas du cadre de l'invention si on ajoutait à la composition au moins un autre polymère de manière à diminuer le coût de la composition. De manière préférée, on utilisera un polymère partiellement miscible ou miscible avec le polymère greffé polyamide. L'homme du métier saura choisir les polymères miscibles ou partiellement miscibles avec le polymère greffé polyamide. Par exemple, on peut utiliser une polyoléfine ou un polyamide de même type que celui utilisé pour fabriquer le polymère greffé polyamide. On pourra ainsi conserver la nanostructuration dans le cas où le polymère greffé polyamide est nanostructuré. La composition comprend de manière avantageuse au moins 25%, préférentiellement au moins 41% et de manière encore plus préférée au moins 75% en masse de polymère greffé polyamide.

Avantageusement, la température d'écoulement de la composition, définie comme la température la plus élevée parmi la température d'écoulement du polymère greffé polyamide et les températures de fusion et de transition vitreuse des autres polymères de la composition, est inférieure à 160°C. De manière préférée, la température la plus élevée parmi la température d'écoulement de la composition est égale à la température d'écoulement du polymère greffé polyamide.

Afin de déterminer les températures d'écoulement du polymère greffé polyamide et de la composition, l'homme du métier pourra aisément mesurer les températures de fusion et de transition vitreuse du tronc polyoléfine, des greffons polyamide et des autres polymères par calorimétrie différentielle à balayage, communément appelée DSC, en utilisant une vitesse de chauffe de 10°C par minute.

Parmi la liste d'additifs ci-après, l'homme du métier saura aisément sélectionner leurs quantités afin d'obtenir les propriétés voulues de la composition.

Des agents de couplage peuvent être avantageusement ajoutés afin d'améliorer le pouvoir d'adhérence de la composition lorsque celui-ci doit être particulièrement élevé. Selon l'invention, l'agent de couplage est un ingrédient non polymérique; il peut être organique, cristallin, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes.

Bien qu'une réticulation ne soit pas obligatoire, celle-ci est possible pour encore améliorer les propriétés thermomécaniques de l'encapsulant, en particulier lorsque la température devient très élevée. On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation.

Préférentiellement, la composition ne comprend pas plus de 10% de résine tackifiante et n'en comprend préférentiellement pas. En effet, lorsque ces résines sont ajoutées au polymère greffé polyamide, la transparence de la composition et la résistance au fluage diminuent. Ces résines tackifiantes sont par exemple les colophanes et ses dérivés, les polyterpènes et ses dérivés. De manière surprenante, aucune résine tackifiante n'est nécessaire pour conférer à la composition des propriétés d'adhérence aux différents supports des modules solaires.

Le rayonnement UV entraînant un jaunissement de l'encapsulant, des stabilisants UV peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

Des charges, en particulier minérales, peuvent être ajoutées pour améliorer la tenue thermomécanique de la composition. De façon non limitative, on donnera comme exemples la silice, l'alumine ou les carbonates de calcium ou les nanotubes de carbone. Avantageusement, on utilise des argiles modifiées ou non modifiées qui sont mélangées à l'ordre nanométrique ; ceci permet d'obtenir une composition plus transparente.

Des plastifiants pourront être ajoutés afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des agents retardateurs de flamme pourront également être ajoutés.

On pourra également ajouter des composés colorants ou azurants.

L'invention a également pour objet des structures qui comprennent la composition selon l'invention. Préférentiellement, la structure a une épaisseur comprise entre 5 µm et 2 mm, préférentiellement entre 100µm et 1 mm et encore plus préférentiellement entre 300 et 500 µm. Ces structures peuvent prendre en particulier la forme d'un film. Ces films pourront être avantageusement utilisés pour l'encapsulation des cellules solaires. Ces structures peuvent être monocouches ou multicouches. Pour ces dernières, on peut par exemple associer à la couche de la composition selon l'invention un support, ce support pouvant comprendre des polymères. Comme exemple de polymères, on peut citer les polyoléfines, comme par exemple l' EVA, ces polyoléfines comprenant ou non un monomère insaturé, les ionomères, les polyamides, les polymères fluorés (comme le polyfluorure de vinyle PVF ou le polyflurorure de divinyle PVDF) ou le poly méthacrylate de méthyle (PMMA). On peut également citer comme autre support ceux à partir de métaux ou de tout type de cellule photovoltaïque.

Ces structures peuvent être obtenues à partir du compound décrit précédemment par les techniques classiques de pressage, d'injection, d'extrusion soufflage de gaine, d'extrusion lamination, d'extrusion couchage, d'extrusion à plat (encore appelée extrusion cast) ou encore d'extrusion de feuille par calandrage, toutes ces structures pouvant être éventuellement thermoformées par la suite. On ne sortirait pas du cadre de l'invention si on obtenait directement la structure ou le film selon l'invention sans passer par l'étape du compound.

Généralement, pour former un module solaire, on place successivement sur un backsheet, une première couche d'encapsulant inférieure, une pile photovoltaïque, une seconde couche d'encapsulant supérieure puis une couche protectrice supérieure. On peut trouver en outre des couches additionnelles, et en particulier des couches de liants ou d'adhésifs. Ces différentes couches sont assemblées pour former le module. Il est précisé que les modules photovoltaïques selon l'invention peuvent être constitués de toute structure photovoltaïque comprenant une couche de la composition selon l'invention et ne sont bien évidemment pas limités à ceux présentés dans cette description.

Ainsi, on peut utiliser la composition selon l'invention comme liant à ces différents supports ou comme encapsulant pour former des modules solaires. Dans une version très avantageuse, les couches d'encapsulant (et en particulier la couche d'encapsulant supérieure) sont transparentes conformément aux paramètres donnés dans la présente description. Un moyen d'obtenir cette transparence est d'utiliser une composition dont les greffons polyamide et la polyoléfine sont nanostructurés.

Pour former la pile photovoltaïque, on peut utiliser tout type de capteurs photovoltaïques parmi lesquelles les capteurs dits « massiques » à base de silicium dopé, monocristallin ou polycristallin ; les capteurs en couche mince formées par exemple de silicium amorphe, de tellurure de cadnium, de disiléniure de cuivre-indium ou de matériaux organiques peuvent également être utilisés.

Comme exemples de backsheet que l'on peut utiliser dans les modules solaires, on peut citer de manière non exhaustive des films monocouches ou multicouches à base de polyester, de polymère fluoré (PVF ou PVDF).

On peut également citer comme backsheet, les films comprenant des polyoléfines par exemple du polyéthylène ou du polypropylène, ces polyoléfines pouvant ou non être modifiées. A titre de polyoléfines modifiées, on peut citer les copolymères comprenant de l'éthylène avec au moins un monomère fonctionnel comme par exemple les esters (méth)acryliques insaturés, les acides carboxyliques insaturés ou les anhydrides d'acide carboxylique comme l'anhydride maléique. Ces polyoléfines modifiées peuvent également être un mélange de polyoléfine avec un autre polymère comme par exemple du polyamidepolyamide.

Comme structure particulière de backsheet, on peut citer par exemple les films multicouches polymère fluoré/polyéthylène téréphtalate/polymère fluoré ou encore polymère fluoré/polyéthylène téréphtalate/EVA.

La couche de backsheet peut également être associée à la couche d'encapsulant par les techniques classiques de fabrication de film multicouche. On peut citer par exemple par coextrusion de film par extrusion-soufflage de gaine, par extrusion-laminage, par extrusion-couchage, par extrusion à plat (encore appelée extrusion cast) ou encore par calandrage. La coextrusion d'une couche de la composition selon l'invention comme encapulant avec une couche de polyoléfine comme backsheet.

La plaque protectrice a des propriétés de résistance à l'abrasion et au choc, est transparente et protège les capteurs photovoltaïques de l'humidité extérieure. Pour former cette couche, on peut citer le verre, le PMMA ou toute autre composition polymère réunissant ces caractéristiques.

Pour assembler les différentes couches du module solaire, on peut utiliser tous les types de techniques de pressage comme par exemple le pressage à chaud, le pressage sous vide ou le laminage, en particulier le thermolaminage. Les conditions de fabrication seront aisément déterminées par l'homme du métier en ajustant la température et la pression à la température d'écoulement de la composition.

Pour fabriquer les modules solaires selon l'invention, l'homme du métier peut se référer par exemple au Handbook of Photovoltaic Science and Engineering, Wiley, 2003.

On peut aussi fabriquer une vitre feuilletée, en particulier du verre feuilleté, en utilisant la composition selon l'invention avec les techniques et conditions de mise en oeuvre présentées pour les panneaux solaires.

La présente invention va être maintenant illustrée par des exemples particuliers de réalisation décrits ci-après. Il est précisé que ces exemples ne visent en aucun cas à limiter la portée de la présente invention.

### Exemples

Pour réaliser des exemples de la composition et des structures selon l'invention, on a utilisé les produits suivants :
LOTADER^{®} 7500 : Copolymère d'éthylène, d'acrylate d'éthyle (17,5 % en poids) et d'anhydride maléique (2,8 % en poids) produit par ARKEMA possédant un MFI de 70g/10mn (190°C sous 2,16 kg mesuré selon ASTM D 1238) et une T_{f} égale à 85°C.
LOTADER^{®} 8200 : Copolymère d'éthylène, d'acrylate d'éthyle (6,5 % en poids) et d'anhydride maléique (2,8 % en poids) produit par ARKEMA possédant un MFI (190°C sous 2,16 kg mesuré selon ASTM D 1238) de 200g/10mn et une T_{f} égale à 100°C.
PA6/12 : Copolyamide du caprolactame et du lauryllactame comprenant 80% en masse de lauryllactame et 20% en masse de caprolactame. Ce copolyamide est monofonctionnalisé amine primaire, a une masse molaire moyenne en nombre de 2500 g.mol⁻¹ et possédant une T_{f} égale à 145°C.
LACQTENE^{®} 1020 FN 24: PE basse densité fabriqué par Total Petrochemicals dont le MFI est de 2.1g/10min (ASTM D 1238 - 190°C - 2,16 kg).

Les compositions selon l'invention (EX1 et EX2) et comparative (CP1) ainsi que leurs ratios massiques sont reportés tableau 1 :

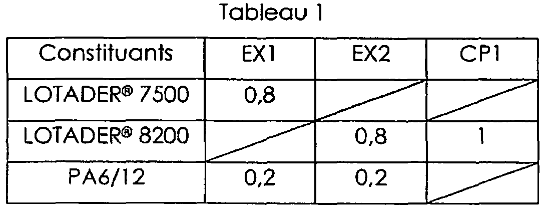

Ces compositions ont été extrudées à 240°C à 300tours/min avec une vis ayant une dimension L/D égale à 44 pour former un compound. Les deux compounds obtenus sont nanostructurés.

Afin de montrer les propriétés intéressantes des compositions selon l'invention et leur utilisation avantageuse dans les modules solaires, on a également utilisé les compositions comparatives suivantes :
CP2 : Composition à base de lonomère.
CP3 : Composition à base de copolymère EVA comprenant 33% en masse d'acétate de vinyle et ayant un MFI de 45 g/10 min (ASTM D 1238 - 190°C - 2,16 kg) et un peroxyde organique.

Afin d'évaluer les propriétés des exemples et comparatifs, on a réalisé des films par extrusion cast ayant une épaisseur de 0,5mm sur une extrudeuse de laboratoire de type Randcastle.

Le film de la composition CP3 est postérieurement réticulé par un traitement thermique à 150°C pendant 20min sous presse.

La transparence des films a été évaluée en mesurant la transmission des éprouvettes à 560nm ainsi que le niveau de trouble ou haze selon la norme ASTM D1003 avec un illuminant C sous 2°.

La tenue au fluage à 120°C a été déterminée sur des éprouvettes de type IFC découpées dans les films. Le test consiste à appliquer une contrainte de 0,5 MPa pendant 15min à une température donnée et de mesurer l'allongement résiduel après retour à température ambiante.

Le comportement rhéologique en isotherme à 150°C des compositions a été déterminé à l'aide d'un viscosimètre Physica MCR 301 en géométrie plan/plan. Pour tous les échantillons, on a appliqué une rampe de température de 5°C/min de 90°C à 150°C/min puis effectué un palier isotherme à 150°C pendant 30min. Au cours de ce cycle de température, les propriétés viscoélastiques et rhéoloqiques ont été mesurées à une fréquence d'oscillation d'1 Hz. On a reporté les viscosités dynamiques à 150°C au commencement du palier isotherme (à t=0) et au bout de 10 minutes lorsque la viscosité devient stable.

La résistivité électrique transversale a été déterminée à 23°C à l'aide d'un spectromètre diélectrique de type Novocontrol Concept 40. Pour chaque, température un balayage en fréquence a été réalisé entre 0.1 Hz et 10⁶ Hz. On a reporté la résistivité des échantillons à basse fréquence (0,1 Hz), lorsque cette résistivité est indépendante de la fréquence.

On a également évalué l'adhésion de l'EX1 sur verre selon le protocole suivant : un film bi-couche de LACQTENE^{®} 1020 FN 24/EX1 a été coextrudé par extrusion cast avec pour épaisseurs respectives 200µm et 20µm. Ce film a été pressé, du côté de l' EX1, sur une plaque de verre de dimensions 200(longueur)x50(largeur)x3(épaisseur) mm³ à 150°C sous 3 bars de pression pendant 20min. L'adhésion est évaluée à partir d'un test de pelage à 90° effectué à 100mm/min sur un dynamomètre Zwyck 1445 et selon la norme ISO8510-1. La largeur du bras de pelage est de 15mm. Lors des tests, il a été observé qu'il n'y a aucune rupture d'adhérence entre le PE et le liant : ainsi, on mesure uniquement la résistance au pelage entre le support en verre et la composition EX1.

Les résultats obtenus sont reportés dans le Tableau 2.

Les exemples des compositions selon l'invention (EX1 et EX2) montrent que les compositions selon l'invention ont une tenue au fluage à 120°C très largement supérieure à celle des ionomères (CP2), qui est également un matériau thermoplastique, le test n'ayant par permis la mesure de l'allongement car le ionomère flue de manière trop importante (>300%). Un autre avantage est la viscosité plus faible lors de la mise en oeuvre des compositions selon l'invention. Ceci permet d'améliorer la productivité lors de la fabrication du compound et des films ou structures utilisant cette composition.

De plus, la transparence des compositions est proche de celle des ionomères. Si on compare EX2 avec CP1, on remarque que la transparence est légèrement améliorée, et que le niveau de trouble est bien meilleur avec la composition selon l'invention.

La résistivité est également similaire à celle observée pour la composition comparative à base d'EVA réticulé.

Les compositions selon l'invention remplissent donc les critères pour pouvoir être très avantageusement utilisée comme liant ou encapsulant dans les modules solaires.

On peut également noter qu'aucun agent de couplage n'est nécessaire pour que la composition ait un pouvoir d'adhérence.

**Tableau 2**

| Exemples | Transmission | Niveau de trouble | Tenue au fluage | Viscosité dynamique t=0 (Pa.s) | Viscosité dynamique t=10min (Pa.s) | Résistivité électrique transversale (Ω.cm) à 23°C | Adhésion sur verre (force de pelage en N/15mm) |
|---|---|---|---|---|---|---|---|
| EX1 | 90,6% | 3% | 10% | 990 | 980 | 5.10¹³ | 11.2 |
| EX2 | 88,8% | 5% | 12.5% | 810 | 620 | 10¹⁴ | Non mesuré |
| CP1 | 87.1% | 40% | Non mesuré | Non mesuré | Non mesuré | Non mesuré | Non mesuré |
| CP2 | 90,4% | Non mesuré | (>300%) | 3100 | 3300 | Non mesuré | Non mesuré |
| CP3 | Non mesuré | Non mesuré | Non mesuré | Non mesuré | Non mesuré | 10¹³ | Non mesuré |

## Revendications

1. Utilisation comme liant et/ou comme encapsulant ou dans les modules solaires d'au moins une composition thermoplastique comprenant un polymère greffé polyamide, ce polymère greffé polyamide comprenant un tronc en polyoléfine contenant un reste d'au moins un monomère insaturé (X) et au moins un greffon en polyamide dans lequel :
• le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
• le reste du monomère insaturé (X) est fixé sur le tronc par greffage ou copolymérisation,
ledit polymère greffé polyamide comprenant :
• de 50 à 95 % en masse du tronc en polyoléfine comprenant le monomère insaturé (X),
• de 5 à 50 % en masse de greffons en polyamide,
et la température d'écoulement de ce polymère greffé polyamide étant supérieure ou égale à 75°C, cette température d'écoulement étant définie comme la température la plus élevée parmi les températures de fusion T_{f} et les températures de transition vitreuse T_{g} du greffon polyamide et du tronc polyoléfine, ladite composition contenant moins de 20% en masse de résine tackifiante par rapport à la masse totale de la composition.

2. Utilisation selon la revendication 1, **caractérisée en ce que** le polymère greffé polyamide comprend de 15 à 30% en masse de greffons en polyamide.

3. Utilisation selon la revendication 1 ou 2, **caractérisée en ce que** ladite composition comprend, en outre, au moins un agent de couplage.

4. Utilisation selon l'une des revendications 1 à 3, **caractérisée en ce que** la température d'écoulement du polymère greffé polyamide est la température de fusion ou la température de transition vitreuse du greffon polyamide.

5. Utilisation selon l'une des revendications 1 à 4, **caractérisée en ce que** la température d'écoulement du polymère greffé polyamide est comprise dans la gamme allant de 115 à 160°C.

6. Utilisation selon l'une des revendications 1 à 4, **caractérisée en ce que** la température d'écoulement du polymère greffé polyamide est comprise dans la gamme allant de 75 à 115°C, et avantageusement de 85 à 115°C.

7. Utilisation selon l'une des revendications 1 à 6, **caractérisée en ce que**, pour un film d'une épaisseur de 500µm et une onde électromagnétique d'une longueur d'onde allant de 400 à 700 nm, la transmission de ladite onde est supérieure ou égale à 80% et/ou le niveau de trouble inférieur ou égal à 10%, la transmission et le niveau de trouble du film étant mesurés selon la norme ASTM D1003.

8. Utilisation selon l'une des revendications 1 à 7, **caractérisée en ce que** la composition est nanostructurée.

9. Utilisation selon l'une des revendications 8, **caractérisée en ce que** la masse molaire en nombre des greffons polyamide est comprise dans la gamme allant de 1000 à 5000g/mol, de préférence comprise dans la gamme allant de 2000 à 3000 g.mol⁻¹.

10. Utilisation selon l'une des revendications 1 à 9, **caractérisée en ce que** les greffons en polyamide comprennent au moins un copolyamide.

11. Utilisation selon l'une des revendications 1 à 10, **caractérisée en ce que** le tronc polyoléfine n'a pas de température de fusion ou a une température de fusion inférieure ou égale à 100°C.

12. Utilisation selon l'une des revendications 1 à 11, **caractérisée en ce que** le nombre de monomère (X) fixé sur le tronc polyoléfine est supérieur ou égal à 1,3 et/ou inférieur ou égal à 10.

13. Utilisation selon l'une des revendications 1 à 12, **caractérisée en ce que** le monomère insaturé (X) est l'anhydride maléique.

14. Utilisation selon l'une des revendications 1 à 13, **caractérisée en ce que** le tronc polyoléfine est un copolymère comprenant un monomère insaturé (X).

15. Utilisation selon la revendication 14, **caractérisée en ce que** le copolymère est un copolymère éthylène-(méth)acrylate d'alkyle comprenant un monomère insaturé (X).

16. Utilisation selon l'une des revendications 1 à 15, **caractérisée en ce que** les extrémités du greffon en polyamide sont une ou des fonctions amine.

17. Utilisation selon l'une des revendications 1 à 16, **caractérisée en ce qu'**elle comprend, en outre, un polymère complémentaire autre qu'une résine tackifiante.

18. Utilisation selon la revendication 17, **caractérisée en ce que** l'autre polymère est miscible ou partiellement miscible avec le polymère greffé polyamide.

19. Utilisation selon l'une des revendications 1 à 18, **caractérisée en ce qu'**elle comprend au moins 75% en masse de polymère greffé polyamide.

20. Utilisation selon l'une des revendications 1 à 19, **caractérisée en ce qu'**elle comprend, en outre, au moins un des composants additionnels choisis parmi les agents réticulant, les absorbants UV, les charges minérales, les plastifiants, les matières colorantes, les azurants optiques et les agents ignifugeant.

21. Module photovoltaïque comprenant une composition utilisée à l'une des revendications 1 à 20.

## Patentansprüche

1. Verwendung mindestens einer thermoplastischen Zusammensetzung, umfassend ein Polyamid-Pfropfpolymer, wobei dieses Polyamid-Pfropfpolymer eine Polyolefin-Hauptkette, die einen Rest mindestns eines ungesättigten Monomers (X) enthält, und mindestens einen Polyamid-Pfropfanteil umfasst, wobei
• der Polyamid-Pfropfanteil über den Rest des ungesättigten Monomers (X) mit einer Funktion, die über eine Kondensationsreaktion mit einem Polyamid mit mindestens einer Aminendgruppe und/oder mindestens einer Carbonsäureendgruppe reagieren kann, an die Polyolefin-Hauptkette gebunden ist,
• der Rest des ungesättigten Monomers (X) durch Pfropfung oder Copolymerisation an der Hauptkette fixiert ist,
wobei das Polyamid-Pfropfpolymer
• 50 bis 95 Gew.-% der Polyolefin-Hauptkette, die das ungesättigte Monomer (X) umfasst,
• 5 bis 50 Gew.-% Polyamid-Pfropfanteile umfasst und die Fließtemperatur dieses Polyamid-Pfropfpolymers größer gleich 75°C ist, wobei diese Fließtemperatur als die höchste Temperatur unter den Schmelztemperaturen T_{f} und den Glasübergangs-temperaturen Tg des Polyamid-Pfropfanteils und der Polyolefin-Hauptkette definiert ist, wobei die Zusammensetzung mindestens 20 Gew.-% klebrigmachendes Harz, bezogen auf das Gesamtgewicht der Zusammensetzung, enthält,
als Bindemittel und/oder Verkapselungsmittel oder in Solarmodulen.

2. Verwendung nach Anspruch 1, **dadurch gekennzeichnet, dass** das Polyamid-Pfropfpolymer 15 bis 30 Gew.-% Polyamid-Pfropfanteile umfasst.

3. Verwendung nach Anspruch 1 oder 2, **dadurch gekennzeichnet, dass** die Zusammensetzung außerdem mindestens ein Kupplungsmittel umfasst.

4. Verwendung nach einem der Ansprüche 1 bis 3, **dadurch gekennzeichnet, dass** es sich bei der Fließtemperatur des Polyamid-Pfropfpolymers um die Schmelztemperatur oder die Glasübergangstemperatur des Polyamid-Pfropfanteils handelt.

5. Verwendung nach einem der Ansprüche 1 bis 4, **dadurch gekennzeichnet, dass** die Fließtemperatur des Polyamid-Pfropfpolymers im Bereich von 115 bis 160°C liegt.

6. Verwendung nach einem der Ansprüche 1 bis 4, **dadurch gekennzeichnet, dass** die Fließtemperatur des Polyamid-Pfropfpolymers im Bereich von 75 bis 115°C und vorteilhafterweise 85 bis 115°C liegt.

7. Verwendung nach einem der Ansprüche 1 bis 6, **dadurch gekennzeichnet, dass** für einen Film mit einer Dicke von 500 µm und eine elektromagnetische Welle mit einer Wellenlänge von 400 bis 700 nm die Transmission der Welle größer gleich 80% und/oder der Trübungsgrad kleiner gleich 10% ist, wobei die Transmission und der Trübungsgrad des Films gemäß der ASTM-Norm D1003 gemessen werden.

8. Verwendung nach einem der Ansprüche 1 bis 7, **dadurch gekennzeichnet, dass** die Zusammensetzung nanostrukturiert ist.

9. Verwendung nach einem der Ansprüche 1 bis 8, **dadurch gekennzeichnet, dass** das zahlenmittlere Molekulargewicht der Polyamid-Pfropfanteile im Bereich von 1000 bis 5000 g/mol, vorzugsweise im Bereich von 2000 bis 3000 g.mol⁻¹, liegt.

10. Verwendung nach einem der Ansprüche 1 bis 9, **dadurch gekennzeichnet, dass** die Polyamid-Pfropfanteile mindestens ein Copolyamid umfassen.

11. Verwendung nach einem der Ansprüche 1 bis 10, **dadurch gekennzeichnet, dass** die Polyolefin-Hauptkette keine Schmelztemperatur oder eine Schmelztemperatur kleiner gleich 100 °C aufweist.

12. Verwendung nach einem der Ansprüche 1 bis 11, **dadurch gekennzeichnet, dass** die Zahl der an der Polyolefin-Hauptkette fixierten Monomere (X) größer gleich 1,3 und/oder kleiner gleich 10 ist.

13. Verwendung nach einem der Ansprüche 1 bis 12, **dadurch gekennzeichnet, dass** es sich bei dem ungesättigten Monomer (X) um Maleinsäureanhydrid handelt.

14. Verwendung nach einem der Ansprüche 1 bis 13, **dadurch gekennzeichnet, dass** es sich bei der Polyolefin-Hauptkette um ein Copolymer, das ein ungesättigtes Monomer (X) umfasst, handelt.

15. Verwendung nach Anspruch 14, **dadurch gekennzeichnet, dass** es sich bei dem Copolymer um ein Ethylen-Alkyl(meth)acrylat-Copolymer, das ein ungesättigtes Monomer (X) umfasst, handelt.

16. Verwendung nach einem der Ansprüche 1 bis 15, **dadurch gekennzeichnet, dass** es sich bei den Endgruppen des Polyamid-Pfropfanteils um eine Aminfunktion oder Aminfunktionen handelt.

17. Verwendung nach einem der Ansprüche 1 bis 16, **dadurch gekennzeichnet, dass** sie außerdem ein anderes komplementäres Polymer als ein klebrigmachendes Harz umfasst.

18. Verwendung nach Anspruch 17, **dadurch gekennzeichnet, dass** das andere Polymer mit dem Polyamid-Pfropfpolymer mischbar oder teilweise mischbar ist.

19. Verwendung nach einem der Ansprüche 1 bis 18, **dadurch gekennzeichnet, dass** sie mindestens 75 Gew.-% Polyamid-Pfropfpolymer umfasst.

20. Verwendung nach einem der Ansprüche 1 bis 19, **dadurch gekennzeichnet, dass** sie außerdem mindestens eine der zusätzlichen Komponenten umfasst, die aus Vernetzungsmitteln, UV-Absorbern, mineralischen Füllstoffen, Weichmachern, Farbstoffen, optischen Aufhellern und Flammschutzmitteln ausgewählt sind.

21. Photovoltaikmodul, umfassend eine in einem der Ansprüche 1 bis 20 verwendete Zusammensetzung.

## Claims

1. Use, as a tie and/or as an encapsulant or in solar modules of at least one thermoplastic composition comprising a polyamide-grafted polymer, this polyamide-grafted polymer comprising a polyolefin backbone containing a residue of at least one unsaturated monomer (X) and at least one polyamide graft in which:
• the polyamide graft is attached to the polyolefin backbone by the residue of the unsaturated monomer (X) that comprises a functional group capable of reacting via a condensation reaction with a polyamide having at least one amine end group and/or at least one carboxylic acid end group;
• the reside of the unsaturated monomer (X) is attached to the backbone by grafting or copolymerization,
said polyamide-grafted polymer comprising:
• from 50 to 95% by weight of the polyolefin backbone comprising the unsaturated monomer (X); and
• from 5 to 50% by weight of polyamide grafts,
and the flow temperature of this polyamide-grafted polymer being greater than or equal to 75°C, this flow temperature being defined as the highest temperature among the melting points Tₘ and the glass transition temperatures T_{g} of the polyamide graft and of the polyolefin backbone, said composition containing less than 20% by weight of tackifying resin relative to the total weight of the composition.

2. Use according to Claim 1, **characterized in that** the polyamide-grafted polymer comprises from 15 to 30% by weight of polyamide grafts.

3. Use according to Claim 1 or 2, **characterized in that** said composition comprises, in addition, at least one coupling agent.

4. Use according to one of Claims 1 to 3, **characterized in that** the flow temperature of the polyamide-grafted polymer is the melting point or the glass transition temperature of the polyamide graft.

5. Use according to one of Claims 1 to 4, **characterized in that** the flow temperature of the polyamide-grafted polymer is in the range from 115 to 160°C.

6. Use according to one of Claims 1 to 4, **characterized in that** the flow temperature of the polyamide-grafted polymer is in the range from 75 to 115°C, and advantageously from 85 to 115°C.

7. Use according to one of Claims 1 to 6, **characterized in that**, for a film having a thickness of 500 µm and an electromagnetic wave with a wavelength ranging from 400 to 700 nm, the transmission of said wave is greater than or equal to 80% and/or the degree of haze is less than or equal to 10%, the transmission and the degree of haze of the film being measured according to the ASTM D1003 standard.

8. Use according to one of Claims 1 to 7, **characterized in that** the composition is nano-structured.

9. Use according to one of Claims 1 to 8, **characterized in that** the number-average molecular weight of the polyamide grafts is in the range from 1000 to 5000 g/mol, preferably in the range from 2000 to 3000 g/mol.

10. Use according to one of Claims 1 to 9, **characterized in that** the polyamide grafts comprise at least one copolyamide.

11. Use according to one of Claims 1 to 10, **characterized in that** the polyolefin backbone does not have a melting point or has a melting point less than or equal to 100°C.

12. Use according to one of Claims 1 to 11, **characterized in that** the number of monomers (X) attached to the polyolefin backbone is greater than or equal to 1,3 and/or less than or equal to 10.

13. Use according to one of Claims 1 to 12, **characterized in that** the unsaturated monomer (X) is maleic anhydride.

14. Use according to one of Claims 1 to 13, **characterized in that** the polyolefin backbone is a copolymer comprising an unsaturated monomer (X).

15. Use according to Claim 14, **characterized in that** the copolymer is an ethylene/alkyl (meth)acrylate copolymer comprising an unsaturated monomer (X).

16. Use according to one of Claims 1 to 15, **characterized in that** the end groups of the polyamide graft are one or some amine functional groups.

17. Use according to one of Claims 1 to 16, **characterized in that** it comprises, in addition, a complementary polymer other than a tackifying resin.

18. Use according to Claim 17, **characterized in that** the other polymer is miscible or partially miscible with the polyamide-grafted polymer.

19. Use according to one of Claims 1 to 18, **characterized in that** it comprises at least 75% by weight of polyamide-grafted polymer.

20. Use according to one of Claims 1 to 19, **characterized in that** it comprises, in addition, at least one of the additional components chosen from crosslinking agents, UV absorbers, mineral fillers, plasticizers, dyestuffs, optical brighteners and fire retardants.

21. Photovoltaic module comprising a composition used according to one of Claims 1 to 20.
